# EUROPÄISCHE PATENTANMELDUNG

(11) **EP 1 996 001 A2**
(43) Veröffentlichungstag der Anmeldung: **26.11.2008**
(21) Anmeldenummer: 08008224.1
(22) Anmeldetag: 30.04.2008
(51) Int. Cl.: H05K 3/04

(54) **Verfahren zur Herstellung eines Substrats**

(30) Priorität: 23.05.2007 DE 102007024290
(71) Anmelder: Bolfek, Zeljko, 08223 Falkenstein (DE)
(72) Erfinder: Bolfek, Zeljko, 08223 Falkenstein (DE)
(74) Vertreter: Neymeyer, Franz

(57) **Zusammenfassung**

Die Erfindung betrifft ein Verfahren zur Herstellung eines Substrats, bei welchem elektrisch leitende Leiterbahnen (13) auf einem Schaltungsträger (16) angeordnet sind, wobei das Layout der Leiterbahnen (13) aus einem metallischen, bandförmigen Leitermaterial (5) durch einen Stanzprozess gestanzt wird, die Leiterbahnen (13) zur Bildung eines Zwischenproduktes auf ein Klebeband (2) appliziert werden, das Zwischenprodukt einer Presse (18) zugeführt wird und, die auf dem Klebeband (2) angeordneten Leiterbahnen (13) durch die Presse (18) auf den Schaltungsträger (16) aufgeklebt werden. Um ein Substrat in einem möglichst kontinuierlichen Herstellungsablauf und mit insbesondere äußert feinen Leiterbahnstrukturen herzustellen, ist erfindungsgemäß vorgesehen, dass die Leiterbahnen (13) beim Stanzvorgang mittels Stanzstempeln (21) durch formangepasste Matrizenkanäle (22) einer Stanzmatrize (9) hindurch gepresst werden und, dass das Klebband (2) im Auswurfbereich der Matrizenkanäle (22) an den Matrizenkanälen (22) vorbeigeführt und das Klebeband (2) mittels eines Presstempels (11) einer Stanzpresse (8) gegen die gestanzten Leiterbahnen (13) zur Applikation auf dem Klebeband (2) gepresst wird.

## Beschreibung

Die Erfindung betrifft ein Verfahren zur Herstellung eines Substrats, bei welchem elektrisch leitende Leiterbahnen auf einem Schaltungsträger angeordnet sind, wobei das Layout der Leiterbahnen aus einem metallischen, bandförmigen Leitermaterial durch einen Stanzprozess gestanzt wird, die Leiterbahnen zur Bildung eines Zwischenproduktes auf ein Klebeband appliziert werden, das Zwischenprodukt einer Presse zugeführt wird und die auf dem Klebeband angeordneten Leiterbahnen durch die Presse auf den Schaltungsträger auf den Schaltungsträger aufgeklebt werden.

Verfahren zur Herstellung eines Substrats sind schon seit langem bekannt und dienen dazu, elektrische Leiterbahnen auf einen Schaltungsträger aufzubringen. Hierzu sei beispielsweise auf die DE 101 47 890 B4 verwiesen. Bei dem in dieser Patentschrift beschriebenen Verfahren besteht das Substrat beispielsweise aus einem Keramikmaterial, auf dessen Oberfläche eine strukturierte Metallschicht aufgebracht ist, welche die Leiterbahnen bildet. Nach der Herstellung eines solchen Substrats sind auf den Leiterbahnen elektronische Bauteile zum Aufbau verschiedener Schaltkreise aufbringbar. Bei dem genannten Verfahren zur Herstellung der Leiterbahnen wird ein Substrat verwendet, das ein Keramikmaterial aus Aluminiumoxid und eine aus diesem Keramikmaterial bestehende Oberfläche aufweist, die mit einer Metallschicht bedeckt ist. Auf diese Metallschicht wird eine flächig deckende fotoempfindliche Maske aufgebracht, die nach einer Belichtung und nachfolgenden Entwicklung die Struktur der Leiterbahnen erzeugt. Dabei wird erreicht, dass in jedem der belichteten Bereiche der Maske ein Oberflächenbereich der Metallschicht frei bleibt, so dass diese freigelegten Oberflächenbereiche abgeätzt werden können, um in diesen Bereichen die Metallschicht vollständig zu entfernen. Nach diesem Ätzvorgang wird die Maske wieder entfernt, so dass das fertige Substrat vorliegt. Anschließend können die elektronischen Bauteile auf diesem Layout bzw. den Leiterbahnen aufgebracht werden.

Solche Substrate bzw. Leiterbahnen werden auch für elektronisch aktive Bauelemente mit hoher Leistungsdichte eingesetzt. Die zunehmende Leistungsdichte solcher aktiven Bauelemente verlangt neue Konzepte und Technologien zur effizienten Entwärmung der elektronischen Komponenten. Beispielsweise bei hocheffizienten Leuchtdiodenanwendungen (Power-LED) hängt die Leistungsausbeute und Lebensdauer u.a. direkt von der thermischen Handhabung ab. Um eine maximale Helligkeit und Lebensdauer zu erreichen, muss die entstehende Wärme schnell und effizient über den Schaltungsträger und einen effektiven Kühlkörper abgeführt werden.

So sind aus dem Stand der Technik Konstruktionen bekannt geworden, mit welchen eine solche "Bauteilkühlung" effektiv bewerkstelligt werden soll.

Aus der DE 42 20 966 C2 ist beispielsweise ein Verfahren zum Herstellen einer Trägerplatte für elektronische Bauteile bekannt geworden, bei welchem unterhalb der Position eines zu kühlenden Bauteils eine Durchgangsöffnung vorgesehen ist. In diese Durchgangsöffnung wird ein "Kühlkörper" als sogenannte bauteilseparate "Wärmesenke" durch eine Pressverbindung eingesetzt. Dabei wird bei der Herstellung die Wärmesenkung bezüglich der Durchgangsöffnung im Untermaß hergestellt und nach dem Einbringen in die Durchgangsöffnung unter Bildung des Presssitzes durch plastische Verformung vergrößert.

Weiter ist aus der DE 101 02 848 B4 ein Verfahren zum formschlüssigen blasenfreien Verkleben von bestückten oder unbestückten gedruckten Schaltungen (Substraten) mit planen Kühlkörpern unter Verwendung einer Klebefolie bekannt. Dabei wird der mit Klebefolie beschichtete Kühlkörper in eine Kammer eingebracht und der bestückte Schaltungsträger dazu lagegenau im Abstand angeordnet. Die Kammer wird anschließend luftdicht verschlossen und nach Erreichen eines entsprechenden Unterdruckes werden die zu verklebenden Teile partiell mechanisch miteinander verpresst. Anschließend erfolgt dann durch Fluten der Kammer eine Flächenpressung und abschließend eine Entpressung durch Aufbringen eines isostatischen Druckes.

Des Weiteren können zur Wärmeabfuhr auch Kühlkörper mit rippenartiger Struktur verwendet werden, wie dies beispielsweise aus der DE 198 15 110 B4 bekannt ist. Bei dieser "Wärmeabführanordnung" ist ein Kühlkörper vorgesehen, der zur Abführung von Wärme aus einem elektrische Komponenten enthaltenden Gehäuse mit diesem fest verbunden ist. Bei dieser Wärmeabführanordnung ist vorgesehen, dass dieses Gehäuse und der Kühlkörper durch eine Klebeschicht fest miteinander verbunden sind. Dabei dichtet diese Klebeschicht das Gehäuse nach außen hin ab. Des Weiteren besitzt diese Klebeschicht eine hohe thermische Leitfähigkeit, so dass eine optimale Wärmeabfuhr zum Kühlkörper vom Substrat gewährleistet ist.

Nachteilig sowohl beim Herstellungsverfahren des Substrats als auch beim Anbringen solcher Kühleinrichtungen ist der recht hohe Herstellungsaufwand.

Aus der US 2 969 300 A ist ein verfahren bekannt, bei welchem aus einer metallischen Folie Leiterbahnstrukturen gestanzt wird. Dazu wird zunächst ein Metallband von einer Spule abgewickelt und in einer Pressstation mit einem aus einem mit einer klebrigen Beschichtung beschichteten Papierband bestehenden Klebeband verbunden. Dieser Verbund wird einer "Stanzpresse" zugeführt, welche einen mit Stanzelementen versehenen Stanzstempel aufweist. Mittels der Stanzelemente werden die Leiterbahnstrukturen in das Metallband gestanzt, ohne dabei das Papierband zu durchschneiden. Anschließend wird das restliche Metallband vom Papierband abgezogen und das Papierband mit den aufgeklebten Leiterbahnstrukturen einer Pressstation zugeführt. Von einer weiteren Zuführeinrichtung werden einzelne, mit einer Kleberbeschichtung versehene Schaltungsträger ebenfalls der Pressstation zugeführt. Mittels eines Pressstempels wird das Papierband mit einer seiner Leiterbahnstrukturen gegen den Schaltungsträger gepresst und einem Härteofen zur Aushärtung der Kleberbeschichtung des Schaltungsträgers zugeführt. Anschließend wird das Papierband abgezogen und die mit den applizierten Leiterbahnstruktur versehenen Schaltungsträger in einer Stapelvorrichtung abgelegt. Nachteilig ist bei diesem Verfahren, dass keine feinen Leiterbahnstrukturen erzeugt werden können.

Aus der De 195 44 480 A1 ist ein Verfahren zur Herstellung eines Substrats bekannt, welches in ähnlicher Weise abläuft. Allerdings werden hier die Leiterbahnstrukturen mittels Laser erzeugt.

Demgemäß liegt der Erfindung die Aufgabe zugrunde, ein Verfahren anzugeben, mit welchem ein Substrat äußerst kostengünstig in einem möglichst kontinuierlichen Verfahrensablauf herstellbar ist, wobei auch äußerst feine Leiterbahnstrukturen herstellbar sein sollen.

Die Aufgabe wird erfindungsgemäß zusammen mit den Merkmalen des Oberbegriffes des Anspruches 1 dadurch gelöst, dass die Leiterbahnen beim Stanzvorgang mittels Stanzstempeln durch formangepasste Matrizenkanäle einer Stanzmatrize hindurch gepresst werden und,
dass das Klebband im Auswurfbereich der Matrizenkanäle an den Matrizenkanälen vorbeigeführt und das Klebeband mittels eines Presstempels einer Stanzpresse gegen die gestanzten Leiterbahnen zur Applikation auf dem Klebeband gepresst wird.

Erfindungsgemäß ist dabei vorgesehen, dass das Layout der Leiterbahnen aus einem metallischen, bandförmigen Leitermaterial durch einen Stanzprozess hergestellt wird. Diese Leiterbahnen werden auf ein Klebeband appliziert, von welchem wiederum die auf dem Klebeband angeordnete Leiterbahn auf den eigentlichen Schaltungsträger beispielsweise mittels einer elektrisch isolierenden hoch wärmeleitfähigen Klebeverbindung aufgeklebt wird. Je nach Anforderungen kann auch jeder andere Geeignete Kleber verwendet werden. Die Strukturierung der Leiterbahnen wird zunächst durch ein Stanzverfahren erzeugt. Dabei werden die erzeugten Leiterbahnen auf eine wärmebeständige Haftschicht bzw. isolierende Zwischenschicht eines Klebebandes aufgebracht und beispielsweise mittels einer sogenannten "Roll to Roll-Technologie" hergestellt. Dadurch wird insbesondere die Arbeitsproduktivität bei der Herstellung eines Substrats signifikant erhöht, wodurch wiederum die Herstellkosten erheblich verringert werden.

Im Vergleich zu konventionellen Herstellungsverfahren von Leiterplatten kann dieser Fertigungsprozess auf galvanische Prozesse sowie foto- und ätztechnische Prozesse verzichten, wodurch eine erheblich geringere Umweltbelastung sowie hohe Energieeinsparungen erreichbar sind. Je nach Wahl des Schaltungsträgers können hier neben ebenen Leiterbahnen auch dreidimensionale Schaltungsträger realisiert werden. Durch die hohe Wärmeleitfähigkeit des Klebers kann dadurch beispielsweise die Lebensdauer von Power-LED erheblich erhöht werden. Insbesondere zum Erzeugen feiner Leiterbahnstrukturen werden die Leiterbahnen beim Stanzvorgang mittels Stanzstempeln durch formangepasste Matrizenkanäle einer Stanzmatrize hindurch gepresst, wobei das Klebband im Auswurfbereich der Matrizenkanäle an den Matrizenkanälen vorbeigeführt und mittels eines Presstempels gegen die gestanzten Leiterbahnen zur Applikation auf dem Klebeband gepresst wird. Dadurch sind auch äußerst dünne Leiterbahnstrukturen erzeugbar.

Weitere vorteilhafte Ausgestaltungen der Erfindung sind den weiteren Unteransprüchen entnehmbar.

So kann gemäß Anspruch 2 vorgesehen sein, dass die Leiterbahnen am Ende des Stanzprozesses aus den Matrizenkanälen der Stanzmatrize um einen Überstand (U) herausragen und mit einer Führungstiefe (T) beim Anpressvorgang auf das Klebeband in den Matrizenkanälen verbleiben. Durch diese Ausgestaltung wird insbesondere eine äußerst präzise Applikation der Leiterbahnen auf dem Klebeband erreicht.

Gemäß Anspruch 3 dass das Klebeband von einer Klebebandspule der Stanzpresse zugeführt, mittels welcher das Leitermaterial gestanzt wird, wodurch ein kontinuierlicher Herstellungsprozess erreicht wird.

Gemäß Anspruch 4 kann das aus Klebeband und aufgeklebten Leiterbahnen bestehende, bandförmige Zwischenprodukt zur Zwischenlagerung auf eine Aufwickelspule aufgewickelt wird. Durch diese Ausgestaltung ist eine einfache und wirtschaftliche Zwischenlagerung des Zwischenproduktes gewährleistet, so dass dieses auch auf Vorrat hergestellt werden kann.

Die gemäß der Ansprüche 5 und 6 vorgesehene Schutzfolie ermöglicht in einem kontinuierlichen Verfahrensablauf insbesondere den Schutz der auf dem Klebeband applizierten Leiterbahnen. Dazu ist gemäß Anspruch 5 vorgesehen, dass das Klebeband mit einer Schutzfolie versehen ist, welche beim Abwickeln des Klebebandes von der Klebebandspule vom Klebeband abgezogen wird. Gemäß Anspruch 6 kann die Schutzfolie beim Aufwickeln des aus dem Klebeband und den Leiterbahnen bestehenden Zwischenproduktes zum Klebeband zurückgeführt werden und die Leiterbahnen abdecken.

Gemäß Anspruch 7 kann vorgesehen sein, dass das Leitermaterial aus einer von einer Kupferspule abwickelbaren, bandförmigen Kupferfolie besteht, welche für den Stanzprozess der Stanzpresse mit ihrem Stanzstempel und ihrer Stanzmatrize zugeführt wird. Je nach Anwendung kann das Leitermaterial auch aus anderen geeigneten Werksoffen bestehen.

Gemäß Anspruch 8 kann die Kupferfolie nach dem Stanzprozess einer Aufwickelspule zugeführt, auf dieser aufgewickelt und beispielsweise einem Recyclingprozess zugeführt werden.

Weiter kann gemäß Anspruch 9 vorgesehen sein, dass der Schaltungsträger zur Fixierung der Leiterbahnen in einer Kleberstation vollflächig oder bereichsweise mit einem Kleber beschichtet wird und, dass der Schaltungsträger nach dessen Beschichtung mit Kleber der Presse zugeführt wird und, dass als Kleber zum Aufkleben auf den Schaltungsträger ein elektrisch isolierender, hoch wärmeleitfähiger Kleber verwendet wird. Insbesondere durch die Verwendung eines elektrisch isolierender, hoch wärmeleitfähiger Klebers werden einerseits eine äußerst gute elektrische Isolierung der einzelnen, einander benachbarten Leiterstrukturen der Leitbahn und andererseits eine hohe Wärmeabfuhr sichergestellt. Durch die elektrisch isolierenden Eigenschaften des Klebers sind weiter auch metallische Werkstoffe für den Schaltungsträger einsetzbar, wodurch die Wärmeabfuhr weiter verbessert wird.

Die Ausgestaltung gemäß Anspruch 10 ist weitestgehend von der Art des verwendeten Klebers zur Fixierung der Leiterbahnen auf dem Schaltungsträger abhängig. Dieser Verfahrensschritt ist lediglich notwendig, wenn ein wärmeaushärtender Kleber verwendet wird. So kann gemäß Anspruch 10 vorgesehen sein, dass der Schaltungsträger zur Aushärtung des Klebers einem Ofen zugeführt wird.

Gemäß Anspruch 11 kann der Schaltungsträger aus einem üblichen Trägermaterial, wie Keramik oder einem hoch wärmeleitfähigen Trägermaterial, insbesondere einem metallischen Werkstoff bestehen. Insbesondere bei der Verwendung eines metallischen Werkstoffes ist eine hohe Wärmeabfuhr sicher, wie bereist oben erwähnt, gewährleistet.

Anhand der Zeichnung werden die Verfahrensabläufe nachfolgend näher erläutert. Es zeigt:
- Fig. 1: eine schematische Darstellung einer Anordnung zum Stanzen eines Layouts von Leiterbahnen und Aufbringen auf ein Klebeband;
- Fig. 2: eine vergrößerte Schnittdarstellung der Stanzmatrize mit auf das Klebeband applizierten Leiterbahnen;
- Fig. 3: eine schematische Darstellung einer Anordnung zum Aufbringen der Leiterbahnen auf einen Schaltungsträger.

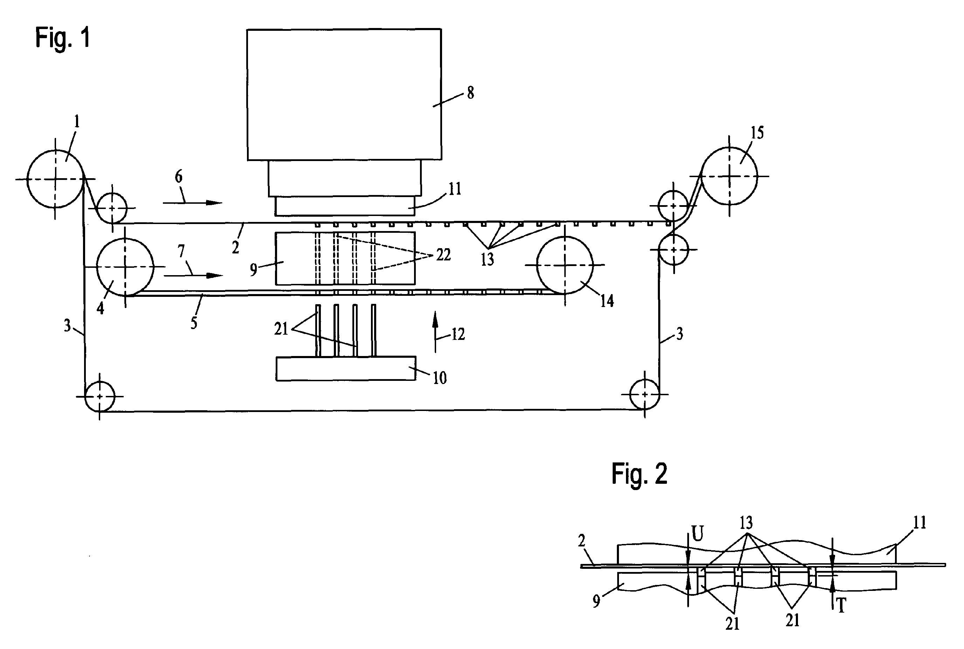

Fig. 1 zeigt auf der linken Seite eine Klebebandspule 1, von welcher ein Klebeband 2 abgespult wird, welches unterseitig mit einer wärmebeständigen Klebeschicht versehen ist. Beim vorliegenden Ausführungsbeispiel ist dieses Klebeband 2 mit einer Schutzfolie 3 versehen, welche beim Abwickelvorgang vom Klebeband 2 abgezogen und parallel zum Klebeband 2 transportiert wird. Des Weiteren ist ebenfalls auf der linken Seite eine Kupferspule 4 vorgesehen, von welcher eine bandförmige Kupferfolie 5 abgespult wird. Das Klebeband 2 und die Kupferfolie 5 werden dabei in Richtung der beiden Pfeile 6 und 7 transportiert und in den Bereich einer Stanzpresse 8 gebracht.

Diese Stanzpresse 8 ist mit einer Stanzmatrize 9 sowie einem Stanzwerkzeug 10 versehen, zwischen welchen die Kupferfolie 5 hindurchgeführt wird. Oberhalb der Stanzmatrize 9 ist ein Pressstempel 11 vorgesehen, unterhalb dessen das Klebeband 2 hindurchgeführt wird. Aus Fig. 1 ist schematisch erkennbar, dass dieses Klebeband 2 zwischen der Stanzmatrize 9 und dem Pressstempel 11 hindurchgeführt wird. Zum Applizieren eines Layouts einer Leiterbahn 13 wird dieses Layout aus der Kupferfolie 5 durch Stanzstempel 21 des Stanzwerkzeuges 10 ausgestanzt und durch entsprechende Matrizenkanäle 22 der Stanzmatrize 9 hindurchgedrückt, wobei am Ende dieser Bewegung des Stanzwerkzeuges 10 in Richtung des Pfeiles 12, d. h., wenn die gestanzten Leiterbahnen 13 im oberen Endbereich der Stanzmatrize 9 angelangt sind, wird der Pressstempel 11 entgegen des Pfeiles 12 zugestellt, so dass die Leiterbahnen 13 auf das Klebeband 2 appliziert werden können. Diese Leiterbahnen 13 sind schematisch mit dem Bezugszeichen 13 gekennzeichnet.

Nach diesem Vorgang der Applikation wird der Pressstempel 11 wiederum zurückgezogen und sowohl das Klebeband 2 als auch die Kupferfolie 3 um eine "Stanzbreite" weitertransportiert. Dabei ist bei diesem Ausführungsbeispiel ausgangsseitig eine Aufwickelspule 14 vorgesehen, auf welche der Rest der Kupferfolie 5 wieder aufgewickelt wird und somit einer Weiterverwertung im Sinne eines Recyclings zuführbar ist.

Das mit den Leiterbahnen 13 versehene Klebeband 2 wird seinerseits wiederum auf eine zweite Aufwickelspule 15 aufgewickelt, wobei bei diesem Ausführungsbeispiel während dieses Aufwickelvorganges die Schutzfolie 3 wiederum die Leiterbahnen 13 abdeckend mit aufgewickelt wird. Somit enthält nunmehr die Aufwickelspule 15 positionsgenau und präzise die Leiterbahnen 13, welche in einem nächsten Verfahrensschritt auf einen Schaltungsträger aufgebracht werden.

Aus Fig. 2 ist ersichtlich, dass die Leiterbahnen 13 am Ende des Stanzprozesses nicht vollständig durch die Stanzstempel 21 aus der Stanzmatrize 9 herausgedrückt werden. Die Leiterbahnen 13 überragen die Stanzmatrize 9 lediglich um einen Überstand U und verbleiben somit mit einem Rest einer Führungstiefe T in der Stanzmatrize 9. Dadurch wird beim anschließenden "Aufpressen" der Leiterbahnen 13 auf das oberhalb angeordnete Klebeband 2 mittels des Presstempels 11 eine höchst präzise Anordnung der Leiterbahnen 13 auf dem Klebeband 2 erreicht.

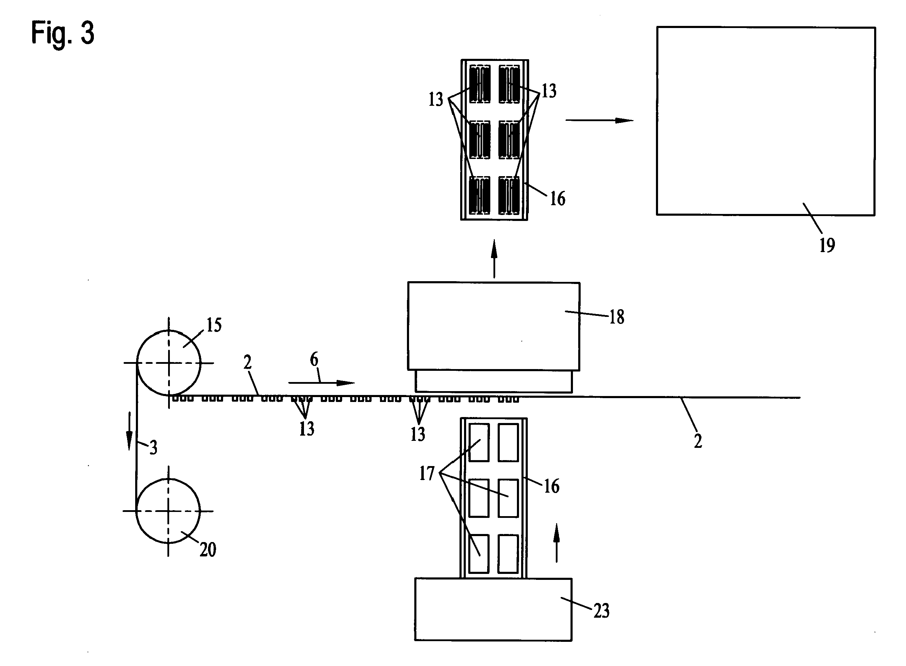

Fig. 3 zeigt schematisch das Aufbringen der Leiterbahnen 13 auf einen Schaltungsträger 16.

In Fig. 3 ist auf der linken Seite die Aufwickelspule 15 aus Fig. 1 erkennbar. Von dieser wird nun das Klebeband 2 mit seinen applizierten Leiterbahnen 13 abgewickelt, wobei parallel zu diesem ein Schaltungsträger 16 bewegt wird. Dieser Schaltungsträger 16 wird, wie dies im mittleren Bereich der Fig. 2 erkennbar ist, in einer Kleberstation 23 oberseitig bereichsweise (oder auch vollflächig) mit einem hoch wärmeleitfähigen Kleber 17 beschichtet, dessen Haftfähigkeit größer **ist als die Klebeschicht** des Klebebandes 2.

Diese Anordnung wird nun entsprechend einer Presse 18 zugeführt, mittels welcher die auf dem Klebeband 2 angeordneten Leiterbahnen 13 im Bereich des Klebers 17 auf dem Schaltungsträger 16 übertragen werden. Anschließend wird der Schaltungsträger 16, je nach Verwendung des Klebemittels einem Ofen 19 zugeführt, durch welchen der auf dem Schaltungsträger 16 angeordnete Kleber zur festen Verbindung der Leiterbahnen 13 mit dem Schaltungsträger 16 aktiviert und ausgehärtet wird.

Die Schutzfolie 3 wird auch während dieses Abwickelprozesses des Klebebandes 2 von der Aufwickelspule 15 abgezogen und auf einer Aufwickelspule 20 aufgewickelt.

Es ist erkennbar, dass durch das erfindungsgemäße Verfahren ein äußerst kostengünstiges Verfahren zur Herstellung eines Substrats zur Verfügung gestellt wird. Dabei zeichnen sich die verwendeten Klebebänder 2 und Kleber 17 durch sehr hohe Klebekraft mit hoher Alterungsbeständigkeit sowie chemischer Resistenz aus.

Des Weiteren sind hier vorzugsweise Klebebänder 2 mit hoher Reißfestigkeit einsetzbar. Die thermische Leitfähigkeit des Klebers 17 ist ebenfalls sehr hoch, so dass der Schaltungsträger 16 beispielsweise auch aus einem metallischen Werkstoff gebildet sein kann, wodurch eine äußerst hohe Wärmeabfuhr gewährleistet ist. In diesem Falle ist als Kleber 17 ein elektrisch isolierender Werkstoff zu verwenden. Solche Kleber 17 können dabei in einer Dicke zwischen 20 Mikrometer bis 150 Mikrometer aufgetragen werden. Die hohe thermische Leitfähigkeit des Klebers 17 wird beispielsweise durch einen 50-%-igen Aluminiumoxid-Anteil erreicht, durch welchen die Entwärmungseigenschaften erheblich verbessert werden. Des Weiteren sind Kupferfolien 5 in Dicken zwischen 9 Mikrometer bis zu 400 Mikrometer verwendbar. Dabei ergibt sich eine Bruchdehnung von ca. 8 %. Die Oberflächen der Kupferfolien 5 können dabei beispielsweise HASL, OSP, Chem. Ni/Au, Chem. Sn oder auch Chem. Ag als Beschichtung aufweisen.

Zusammenfassend ist festzustellen, dass das erfindungsgemäße Verfahren für den Anwender erhebliche Vorteile mit sich bringt. Zum einen sind hier durch den Einsatz preiswerter Kupferfolien oder veredelter Kupferfolien in Stärken zwischen 9 Mikrometer und 400 Mikrometer niedrige Materialkosten gewährleistet.

Das Produktionsverfahren der Schaltungsträgerfolie erfolgt erfindungsgemäß vorzugsweise mittels Roll to Roll-Produktion, so dass die hergestellten Zwischenprodukte aus Klebband 2 und Leiterbahnen 13 auf Vorrat gefertigt werden können. Die Aufwickelspule 15 mit den Zwischenprodukten ist nicht nur Speicher der auf Vorrat gefertigten Zwischenprodukte, sondern stellt ein wichtiges Merkmal für die spätere automatisierte, sichere und präzise Aufbringung der Leiterbahnen auf den Schaltungsträger dar.

Damit lässt sich das Herstellen großer Mengen von Schaltungsträgern von der Montage auf Baugruppen hinsichtlich der Produktionsorganisation entkoppeln. Die Tagesproduktion beispielsweise könnte in einer Verarbeitungsbreite von 200 mm mit einer Tagesgröße von etwa 100 m² durchgeführt werden.

Als Schaltungsträger können nahezu alle Materialien benutzt werden. Auch die geometrische Form des Schaltungsträgers (Gehäuse, Glühkörper usw.) muss nicht eine plane Ebene sein, sondern kann auch geometrisch andere Formen annehmen.

Durch die dünnen Schaltungsträgerfolien sind die Schaltungen sehr flexibel und dabei belastbar. Die Automatisierungslösung der beschriebenen Arbeitsvorgänge ist nicht nur sehr produktiv, sondern löst auch ein wichtiges technisches Problem. Die genaue Positionierung der unbestückten Schaltungsträgerfolie, ohne dass die Layouts beschädigt werden. Damit entsteht insbesondere eine Verwendungsmöglichkeit für sehr dünne Folien.

Die Haftfestigkeit der Leiterbahnen auf dem Schaltungsträger ist dabei in allen Bereichen für mittlere Anforderungen ausreichend.

## Patentansprüche

1. Verfahren zur Herstellung eines Substrats, bei welchem elektrisch leitende Leiterbahnen (13) auf einem Schaltungsträger (16) angeordnet sind, wobei
das Layout der Leiterbahnen (13) aus einem metallischen, bandförmigen Leitermaterial (5) durch einen Stanzprozess gestanzt wird,
die Leiterbahnen (13) zur Bildung eines Zwischenproduktes auf ein Klebeband (2) appliziert werden,
das Zwischenprodukt einer Presse (18) zugeführt wird und,
die auf dem Klebeband (2) angeordneten Leiterbahnen (13) durch die Presse (18) auf den Schaltungsträger (16) aufgeklebt werden,
**dadurch gekennzeichnet,**
**dass** die Leiterbahnen (13) beim Stanzvorgang mittels Stanzstempeln (21) durch formangepasste Matrizenkanäle (22) einer Stanzmatrize (9) hindurch gepresst werden und,
**dass** das Klebband (2) im Auswurfbereich der Matrizenkanäle (22) an den Matrizenkanälen (22) vorbeigeführt und das Klebeband (2) mittels eines Presstempels (11) einer Stanzpresse (8) gegen die gestanzten Leiterbahnen (13) zur Applikation auf dem Klebeband (2) gepresst wird.

2. Verfahren nach Anspruch 1, **dadurch gekennzeichnet, dass** die Leiterbahnen (13) am Ende des Stanzprozesses aus den Matrizenkanälen (22) der Stanzmatrize um einen Überstand (U) herausragen und mit einer Führungstiefe (T) beim Anpressvorgang auf das Klebeband (2) in den Matrizenkanälen (22) verbleiben.

3. Verfahren nach Anspruch 1 oder 2, **dadurch gekennzeichnet, dass** das Klebeband (2) von einer Klebebandspule (1) der Stanzpresse (8) zugeführt wird, mittels welcher das Leitermaterial (5) gestanzt wird.

4. Verfahren nach einem der Ansprüche 1 bis 3, **dadurch gekennzeichnet, dass** das aus Klebeband (2) und aufgeklebten Leiterbahnen (13) bestehende, bandförmige Zwischenprodukt zur Zwischenlagerung auf eine Aufwickelspule (15) aufgewickelt wird.

5. Verfahren nach einem der Ansprüche 2 bis 4, **dadurch gekennzeichnet, dass** das Klebeband (2) mit einer Schutzfolie (3) versehen ist, welche beim Abwickeln des Klebebandes (2) von der Klebebandspule (1) vom Klebeband (2) abgezogen wird.

6. Verfahren nach Anspruch 5, **dadurch gekennzeichnet, dass** die Schutzfolie (3) beim Aufwickeln des aus dem Klebeband (2) und den Leiterbahnen (13) bestehenden Zwischenproduktes zum Klebeband (2) zurückgeführt wird und die Leiterbahnen (13) abdeckt.

7. Verfahren nach einem der Ansprüche 1 bis 6, **dadurch gekennzeichnet, dass** das Leitermaterial aus einer von einer Kupferspule (1) abwickelbaren, bandförmigen Kupferfolie (5) besteht, welche für den Stanzprozess der Stanzpresse (8) mit ihrem Stanzstempel (21) und ihrer Stanzmatrize (9) zugeführt wird.

8. Verfahren nach Anspruch 7, **dadurch gekennzeichnet, dass** die Kupferfolie (5) nach dem Stanzprozess einer Aufwickelspule (14) zugeführt wird und auf dieser aufgewickelt wird.

9. Verfahren nach einem der Ansprüche 1 bis 3, **dadurch gekennzeichnet, dass** der Schaltungsträger (16) zur Fixierung der Leiterbahnen (13) in einer Kleberstation (23) vollflächig oder bereichsweise mit einem Kleber (17) beschichtet wird und, dass der Schaltungsträger (16) nach dessen Beschichtung mit Kleber (17) der Presse (18) zugeführt wird und,
dass als Kleber zum Aufkleben auf den Schaltungsträger (16) ein elektrisch isolierender, hoch wärmeleitfähiger Kleber verwendet wird.

10. Vorrichtung nach Anspruch 10, **dadurch gekennzeichnet, dass** der Schaltungsträger (16) zur Aushärtung des Klebers (17) einem Ofen (19) zugeführt wird.

11. Vorrichtung nach einem der Ansprüche 1 bis 11, **dadurch gekennzeichnet, dass** der Schaltungsträger (16) aus einem üblichen Trägermaterial, wie Keramik oder einem hoch wärmeleitfähigen Trägermaterial, insbesondere einem metallischen Werkstoff besteht.
